# EUROPEAN PATENT APPLICATION

(11) **EP 4 783 795 A1**
(43) Date of publication of application: **29.07.2026**
(21) Application number: 24868518.2
(22) Date of filing: 29.08.2024
(51) Int. Cl.: H10K 30/50, H10K 85/50, H10K 30/15, H10K 30/40, H10K 30/85, H10K 30/86, H10K 30/81, H10K 30/57, H10K 39/15, H10K 71/12

(54) **PEROVSKITE SOLAR CELL AND METHOD FOR PRODUCING SAME**

(30) Priority: 18.09.2023 KR 20230123876
(71) Applicant: Hanwha Solutions Corporation, Jung-gu Seoul 04541 (KR)
(72) Inventor: CHO, An Na, Suwon-si, Gyeonggi-do 16688 (KR); JEONG, Jun Kyeong, Seongnam-si, Gyeonggi-do 13488 (KR)
(74) Representative: Mooser, Sebastian Thomas
(86) International application number: PCT/KR2024/012930
(87) International publication number: WO 2025/063539

(57) **Abstract**

The present invention relates to a perovskite solar cell in which an electron transport buffer layer having a three-layer structure is introduced between a perovskite light-absorbing layer and an electron transport layer, and to a method for producing same.

## Description

### TECHNICAL FIELD

The present invention relates to a perovskite solar cell including an additive in a hole transport layer and introducing an interlayer between a hole transport layer and a perovskite light-absorbing layer, and a method for manufacturing the same.

### BACKGROUND ART

In order to solve the global environmental problems caused by the depletion of fossil fuels and the usage thereof, research on renewable and clean alternative energy sources such as solar energy, wind power and hydropower is being actively conducted.

Among these, interest in solar cells that directly convert electrical energy from sunlight is increasing significantly. Here, a solar cell refers to a cell that generates current-voltage by using the photovoltaic effect that generates electrons and holes by absorbing light energy from sunlight.

Currently, it is possible to manufacture n-p diode-type silicon (Si) single crystal-based solar cells with a light energy conversion efficiency of over 20%, and they are actually being used for solar power generation, and there are also solar cells using compound semiconductors such as gallium arsenide (GaAs) with an even higher conversion efficiency. However, since these inorganic semiconductor-based solar cells require highly purified materials to achieve high efficiency, a lot of energy is consumed in refining the raw materials, and expensive process equipment is required in the process of using the raw materials to make a single crystal or thin film, which limits the cost of lowering the manufacturing cost of solar cells, and this has been an obstacle to large-scale utilization.

Accordingly, in order to manufacture solar cells at low cost, it is necessary to drastically reduce the cost of materials or manufacturing processes used as core elements of solar cells, and research is being conducted on perovskite solar cells that can be manufactured by using low-cost materials and processes as an alternative to inorganic semiconductor-based solar cells.

Recently, perovskite solar cells using (NH₃CH₃)PbX₃ (X = I, Br, Cl), which is a halogen compound with a perovskite structure, as a photoactive agent have been developed, and research is being conducted toward commercialization. The general structural formula of the perovskite structure is the ABX₃ structure, where an anion is located in the X position, a large cation is located in the A position, and a small cation is located in the B position.

Meanwhile, perovskite solar cells are being developed in the structure of P-IN perovskite single solar cells or two-terminal perovskite/silicon tandem solar cells. In the case of two-terminal perovskite/silicon tandem solar cells, a recombination layer is formed on glass and a lower silicon solar cell, and then, upper perovskite solar cell layers, such as a hole transport layer, a perovskite light-absorbing layer, an electron transport layer and a transparent electrode, are sequentially formed to manufacture a two-terminal perovskite/silicon tandem solar cell.

In the conventional technology, the hole transport layer can be formed through a deposition process or a solution process. However, if the hole transport layer is formed through a deposition process, not only does the manufacturing cost increase, but target development is also necessary to add various additives to improve performance. In addition, if the hole transport layer is formed through a solution process, there is a problem that the hole transport layer is formed unevenly compared to the deposition process, and this causes a problem of reduced performance of the perovskite solar cell.

### DISCLOSURE

### TECHNICAL PROBLEM

The present invention has been devised to overcome the above-described problems, and aims to provide a perovskite solar cell and a method for manufacturing the same, which not only improve the characteristics of a hole transport layer by including an additive in the hole transport layer and introducing an interlayer between the hole transport layer and the perovskite light-absorbing layer, but also improves the performance of a perovskite solar cell by forming the hole transport layer into a uniform thin film.

In addition, the present invention aims to provide a perovskite solar cell and a method for manufacturing the same, which are more economical than those obtained by performing a deposition process by forming a hole transport layer through a solution process.

### TECHNICAL SOLUTION

In order to solve the above-described problems, the perovskite solar cell of the present invention may include a laminate in which a hole transport layer, a perovskite light-absorbing layer, an electron transport layer, a transparent electrode and a metal electrode are sequentially laminated, wherein an interlayer may be formed between the hole transport layer and the perovskite light-absorbing layer, and wherein the hole transport layer may include an additive.

In a preferred embodiment of the present invention, the additive may include one or more selected from alkali metals and alkaline earth metals.

In a preferred embodiment of the present invention, the hole transport layer may include 1 to 7 mol% of an additive based on the total mol%.

In a preferred embodiment of the present invention, the interlayer may include a self-assembled monolayer including carbazole and phosphonic acid.

In a preferred embodiment of the present invention, the hole transport layer and interlayer may have a thickness ratio of 1 : 0.05 to 0.25.

In a preferred embodiment of the present invention, the perovskite solar cell of the present invention may be a p-i-n structured perovskite solar cell, an n-i-p inverted structured perovskite solar cell, a tandem perovskite solar cell or a tandem silicon/perovskite heterojunction solar cell.

Meanwhile, the method for manufacturing a perovskite solar cell according to the present invention may include a first step of forming a hole transport layer through a solution process on top of a transparent conductive layer; a second step of forming an interlayer on top of the hole transport layer; and a third step of forming a perovskite light-absorbing layer on top of the interlayer, wherein the hole transport layer may include an additive.

In a preferred embodiment of the present invention, the additive may include one or more selected from alkali metals and alkaline earth metals.

In a preferred embodiment of the present invention, the hole transport layer may include 1 to 7 mol% of an additive based on the total mol%.

In a preferred embodiment of the present invention, the interlayer may include a self-assembled monolayer including carbazole and phosphonic acid.

Furthermore, the tandem silicon/perovskite heterojunction solar cell of the present invention is a heterojunction solar cell in which a solar cell, a transparent conductive layer, a hole transport layer, an interlayer, a perovskite light-absorbing layer, an electron transport layer, a transparent electrode and a metal electrode are sequentially laminated, wherein the hole transport layer may include an additive.

In a preferred embodiment of the present invention, the additive may include one or more selected from alkali metals and alkaline earth metals, and the interlayer may include a self-assembled monolayer including carbazole and phosphonic acid.

In a preferred embodiment of the present invention, the hole transport layer may include 1 to 7 mol% of an additive based on the total mol%.

In a preferred embodiment of the present invention, the solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fuel-sensitized solar cell or a Group 3-5 compound solar cell.

### ADVANTAGEOUS EFFECTS

The perovskite solar cell of the present invention includes an additive in a hole transport layer and introduces an interlayer between the hole transport layer and the perovskite light-absorbing layer, thereby not only improving the characteristics of a hole transport layer, but also improving the performance of a perovskite solar cell by forming the hole transport layer into a uniform thin film.

In addition, the method for manufacturing a perovskite solar cell according to the present invention forms a hole transport layer through a solution process, and thus is more economical than performing a deposition process.

### DESCRIPTION OF DRAWINGS

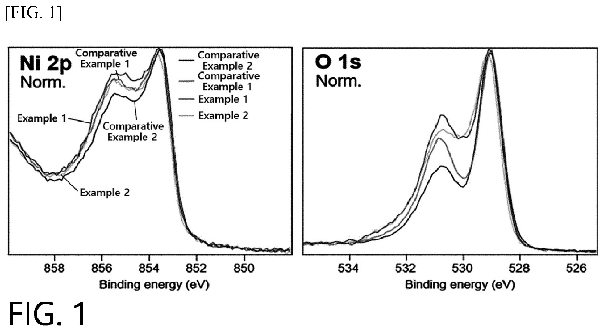

FIG. 1 is a graph showing the intensity according to a change in binding energy at the surface of a hole transport layer for each of the tandem silicon/perovskite heterojunction solar cells manufactured in Examples 1 and 2 and Comparative Examples 1 and 2, as measured by photoelectron spectroscopy (XPS).

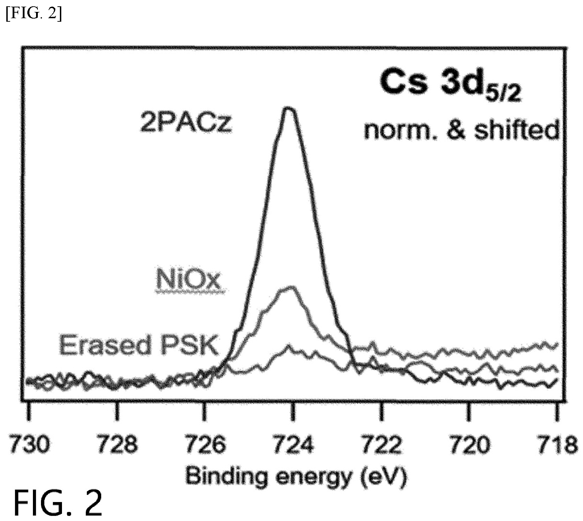

FIG. 2 is a graph showing the intensity change of Cs 3d_{5/2} at the surface in the states of Condition 1 (= indicated as NiOₓ), Condition 2 (= indicated as 2PACs) and Condition 4 (= indicated as Erased PSK) for the tandem silicon/perovskite heterojunction solar cell manufactured in Example 1, as measured by photoelectron spectroscopy (XPS).

### MODES OF THE INVENTION

Hereinafter, the present invention will be described in more detail.

Existing perovskite solar cells can form a hole transport layer through a deposition process or a solution process. However, if the hole transport layer is formed through a deposition process, not only does the manufacturing cost increase, but target development is necessary to add various additives to improve performance. In addition, if the hole transport layer is formed through a solution process, there is a problem that the hole transport layer is formed unevenly compared to the deposition process, and this causes the performance of a perovskite solar cell to deteriorate.

Accordingly, the present invention relates to a perovskite solar cell that not only improves the characteristics of a hole transport layer by including an additive in a hole transport layer and introducing an interlayer between the hole transport layer and the perovskite light-absorbing layer, but also improves the performance of a perovskite solar cell by forming the hole transport layer into a uniform thin film.

The perovskite solar cell of the present invention may be a p-i-n structured type perovskite solar cell, an n-i-p inverted structured type perovskite solar cell, a tandem perovskite solar cell or a tandem silicon/perovskite heterojunction solar cell, preferably a tandem silicon/perovskite heterojunction solar cell, and may be a solar cell including a laminate in which a hole transport layer (HTL), a perovskite light-absorbing layer, an electron transport layer (ETL), a transparent electrode and a metal electrode are sequentially laminated.

In addition, the perovskite solar cell of the present invention may have an interlayer formed between the hole transport layer and the perovskite light-absorbing layer.

For example, in a preferred embodiment, when the perovskite solar cell of the present invention is a tandem silicon/perovskite heterojunction solar cell, it may be a heterojunction solar cell in which a solar cell, a transparent conductive layer, a hole transport layer, an interlayer, a perovskite light-absorbing layer, an electron transport layer, a transparent electrode and a metal electrode are sequentially laminated.

The solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fluorine-sensitized solar cell or a Group 3-t compound solar cell.

In addition, the thickness of the solar cell is not particularly limited, but it may preferably have a thickness of 140 to 250 µm, and more preferably 160 to 200 µm.

The transparent conductive layer is a layer that induces the recombination of electrons and holes generated in the solar cell and the perovskite light-absorbing layer described below, and may be a transparent thin film on which ITO (Indium Tin Oxide), FTO (Fluorine doped Tin Oxide), ATO (Sb₂O₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide) or AZO (Aluminum doped zinc oxide) is deposited.

In addition, as an example of forming a transparent conductive layer, when using a silicon solar cell doped with n or p-type impurities as a solar cell, the silicon solar cell doped with n or p-type impurities is treated with hydrofluoric acid to remove the SiOₓ oxide film, and then, the remaining hydrofluoric acid is removed by using ultrapure water. Then, a transparent conductive layer may be formed on a top end of the silicon solar cell from which the oxide film has been removed through a sputtering process.

In addition, the thickness of the transparent conductive layer is not particularly limited, but it may preferably have a thickness of 5 nm to 50 nm, and more preferably 15 nm to 25 nm.

The hole transport layer (HTL) is a layer that transports holes formed in the perovskite light-absorbing layer described below while blocking the movement of electrons, and may include an inorganic and/or organic hole transport material.

In this case, the inorganic hole transport material may include one or more selected from nickel oxide (NiOₓ), CuSCN, CuCrO₂, CuI, MoO and V₂O₅, and most preferably, nickel oxide (NiOₓ).

In addition, the organic hole transport material may include one or more selected from a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene-based derivative, a polypyrrole derivative, a polyparaphenylenevinylene derivative, pentacene, coumarin 6 (coumarin 6, 3-(2-benzothiazolyl)-7-(diethylamino)coumarin), ZnPC (zinc phthalocyanine), CuPC (copper phthalocyanine), TiOPC (titanium oxide phthalocyanine), Spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc (boron subphthalocyanine chloride) and N3 (cis-di(thiocyanato)-bis(2,2'-bipyridyl-4,4'-dicarboxylic acid)-ruthenium(II), P3HT (poly[3-hexylthiophene]), MDMO-PPV (poly[2-methoxy-5-(3',7'-dimethyloctyloxyl)]-1,4-phenylene vinylene), MEH-PPV(poly[2-methoxy-5-(2"-ethylhexyloxy)-p-phenylene vinylene]), P3OT(poly(3-octyl thiophene)), POT (poly(octyl thiophene)), P3DT (poly(3-decyl thiophene)), P3DDT (poly(3-dodecyl thiophene), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrkis (N,N-di-pmethoxyphenyl amine)-9,9,9"-spirobi fluorine]), PCPDTBT (Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT (poly[(4,4"-bis(2-ethylhexyl)dithieno[3,2-b:2",3"-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4', 7, -di-2-thienyl-2',1', 3'-benzothiadiazole)]), PFO-DBT (poly[2,7-.9,9-(dioctyl-fluorene)-alt-5,5-(4',7'-di-2-.thienyl-2', 1', 3'-benzothiadiazole)]), PSiFDTBT (poly[(2,7-dioctylsilafluorene)-2,7-diyl-alt-(4,7-bis(2-thienyl)-2,1,3-benzothiadiazole)-5,5"-diyl]), PCDTBT (Poly [[9-(1-octylnonyl)-9H-carbazole-2,7-diyl] -2,5-thiophenediyl-2,1,3-benzothiadiazole-4,7-diyl-2,5-thiophenediyl]), PFB (poly(9,9"-dioctylfluorene-co-bis(N,N"-(4,butylphenyl))bis(N,N"-phenyl-1,4-phenylene)diamine), F8BT (poly(9,9"-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, MeO-2PACz, Br-2PACz, Me-4PACz, MeO-4PACz and 6-PACz.

In addition, as a method for forming a hole transport layer, examples thereof include a coating method and a vacuum deposition method, and examples of the coating include a gravure coating method, a bar coating method, a printing method, a spray method, a spin coating method, a dip method and a die coat method. Preferably, the hole transport layer may be formed through a deposition process or a solution process, and most preferably, the hole transport layer may be formed through spin coating among solution processes.

Meanwhile, the hole transport layer of the present invention may include an additive. The additive may include one or more selected from alkali metals and alkaline earth metals, preferably include one or more selected from cesium element, lithium element, sodium element, potassium element, rubidium element, zinc element and molybdenum element, and more preferably include cesium element.

Specifically, the hole transport layer may include the additive in an amount of 1 to 7 mol%, preferably 1 to 4 mol%, and more preferably 1.5 to 2.5 mol%, based on the total mol%. If the additive is included in an amount of less than 1 mol%, there may be a problem in covering the entire hole transport layer, and if it is included in an amount of more than 7 mol%, there may be a problem in hindering the flow of charges.

In addition, the thickness of the hole transport layer is not particularly limited, but it may preferably have a thickness of 5 nm to 40 nm, and more preferably 10 nm to 30 nm.

The interlayer may include a self-assembled monolayer including carbazole and phosphonic acid, preferably include one or more selected from 2PACz ([2-(9H-Carbazol-9-yl)ethyl]phosphonic acid)), Me-2PACz, MeO-2PACz, 4PACz, Me-4PACz and MeO-4PACz, and preferably include 2PACz.

Methods for forming the interlayer include a coating method and a vacuum deposition method, and examples of the coating method include a gravure coating method, a bar coating method, a printing method, a spray method, a spin coating method, a dip method and a die coat method. Preferably, the interlayer may be formed through a deposition process or a solution process, and most preferably, the interlayer may be formed through spin coating among solution processes.

The thickness of the interlayer is not particularly limited, but it may preferably have a thickness of 0.1 nm to 10 nm, and more preferably 1 nm to 5 nm.

Meanwhile, the hole transport layer and the interlayer may have a thickness ratio of 1 : 0.05 to 0.25, preferably 1 : 0.1 to 0.2, and more preferably 1 : 0.13 to 0.17. If the thickness ratio is less than 1 : 0.05, there may be a problem in covering the entire hole transport layer, and if it exceeds 1 : 0.25, there may be a problem in that excessive coating may occur, which may hinder the flow of charges.

The perovskite light-absorbing layer may include a general perovskite material applied to a light-absorbing layer of a solar cell, and as a preferred example, it may include a perovskite material represented by Chemical Formula 1 below.

[Chemical Formula 1] CMX₃

In Chemical Formula 1 above, C is a monovalent cation, which may include an amine, ammonium, a Group 1 metal, a Group 2 metal and/or other cations or cation-like compounds, and preferably, it may be formamidinium (FA), methylammonium (MA. methylammonium), FAMA, CsFAMA, CsFA or N(R)⁴⁺ (here, R may be the same or different groups, and R is a straight-chain alkyl group having 1 to 5 carbon atoms, a branched alkyl group having 3 to 5 carbon atoms, a phenyl group, an alkylphenyl group, an alkoxyphenyl group or an alkyl halide).

In addition, M in Chemical Formula 1 is a divalent cation, which may include one or two selected from Fe, Co, Ni, Cu, Sn, Pb, Bi, Ge, Ti, Eu and Zr.

In addition, X in Chemical Formula 1 is a monovalent anion, which may include one or more halide elements selected from F, Cl, Br and I and/or a Group 16 anion. As a preferred example, X may be IxBr₃₋ₓ (0 ≤ x ≤ 3).

In addition, a preferable embodiment of Chemical Formula 1 may be FAPbIₓBr₃₋ₓ (0 ≤ x ≤ 3), MAPbIₓBr₃₋ₓ (0 ≤ x ≤ 3), CSFAPbIₓBr₃₋ₓ (0 ≤ x ≤ 3), CSMAFAPbIₓBr₃₋ₓ (0 ≤ x ≤ 3), CH₃NH₃PbX₃ (X = Cl, Br, I, BrI₂ or Br₂I), CH₃NH₃SnX₃ (X = Cl, Br or I), CH(=NH)NH₃PbX₃ (X = Cl, Br, I, BrI₂ or Br₂I) or CH(=NH)NH₃SnX₃ (X = Cl, Br or I).

Meanwhile, in the perovskite solar cell of the present invention, the perovskite light-absorbing layer may be a single layer composed of the same perovskite material, or may be a multilayer structure in which multiple layers composed of different perovskite materials are laminated, and may include a heterogeneous perovskite material that is different from the one type of perovskite material having a pillar shape such as a columnar shape, a plate shape, a needle shape, a wire shape or a rod shape inside the light-absorbing layer composed of one type of perovskite material.

In addition, methods for forming the perovskite light-absorbing layer include a coating method and a vacuum deposition method, and examples of the coating method include a gravure coating method, a bar coating method, a printing method, a spray method, a spin coating method, a dip method, an inkjet coating method and a die coat method.

The electron transport layer (ETL) is a layer that transports electrons formed in the perovskite light-absorbing layer while blocking the movement of holes, and may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH) and niobium pentoxide (Nb₂O₅).

In addition, methods for forming the electron transport layer include a coating method, an ALD deposition method and/or a vacuum deposition method, and examples of the coating method include a gravure coating method, a bar coating method, a printing method, a spray method, a spin coating method, a dip method and a die coat method.

In addition, the thickness of the electron transport layer is not particularly limited, but it may have an average thickness of preferably 3 to 30 nm, more preferably 3 to 15 nm, and even more preferably 8 to 13 nm.

The transparent electrode may be formed on top of the electron transport layer through a deposition process. In this case, the deposition may be performed by using a general deposition process used in the art, and preferably, the deposition process may be performed by using a sputtering method.

In addition, the transparent electrode may be a transparent thin film on which ITO (Indium Tin Oxide), FTO (Fluorine doped Tin Oxide), ATO (Sb2O3 doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide) or AZO (Aluminum doped zinc oxide) is deposited.

In addition, the thickness of the transparent electrode is not particularly limited, but it may preferably have a thickness of 50 to 200 nm, and more preferably 50 to 140 nm.

The metal electrode may be formed by patterning a metal material on top of a transparent electrode. Specifically, the patterning process is largely composed of deposition, exposure (lithography) and etching. The metal electrode may be formed on top of the transparent electrode through the process of spreading a metal material in the form of a thin film on one surface of a substrate, printing a pattern by exposure, and then removing unnecessary portions. In addition, the patterning process may also be performed through a screen printing method using a metal paste including a metal material.

In this case, the metal material may include one or more selected from Pt, Au, Ni, Cu, Ag, In, Ru, Pd, Rh, Ir, Os, C and a conductive polymer.

In addition, the thickness of the metal electrode is not particularly limited, but it may preferably have a thickness of 50 nm to 2.5 µm.

Meanwhile, the method for manufacturing a perovskite solar cell according to the present invention may include a first step of forming a hole transport layer through a solution process on top of a transparent conductive layer, a second step of forming an interlayer on top of the hole transport layer, and a third step of forming a perovskite light-absorbing layer on top of the interlayer. In this case, the hole transport layer may include an additive. The additive may include one or more selected from alkali metals and alkaline earth metals, preferably, it may include one or more selected from cesium element, lithium element, sodium element, potassium element, rubidium element, zinc element and molybdenum element, and more preferably, it may include cesium element.

Specifically, the hole transport layer may include 1 to 7 mol%, preferably 1 to 4 mol%, and more preferably 1.5 to 2.5 mol% of the additive, based on the total mol%.

In addition, the interlayer may include a self-assembled monolayer including carbazole and phosphonic acid, preferably, it may include one or more selected from 2PACz ([2-(9H-Carbazol-9-yl)ethyl]phosphonic acid)), Me-2PACz, MeO-2PACz, 4PACz, Me-4PACz and MeO-4PACz, and preferably, it may include 2PACz.

Hereinafter, the present invention will be described more specifically through examples, but the following examples do not limit the scope of the present invention, and should be interpreted as helping to understand the present invention.

### Example 1: Manufacture of tandem silicon/perovskite heterojunction solar cell

(1) A silicon solar cell (thickness: 180 µm) doped with n or p-type impurities was prepared, the SiOₓ oxide film was removed by treating hydrofluoric acid, and the remaining hydrofluoric acid was removed by using ultrapure water. A 20 nm thick transparent conductive layer (ITO) was formed on top of the silicon solar cell from which the oxide film was removed through a sputtering process.
(2) Next, a NiOₓ nano colloidal solution including an additive was spin-coated on top of the transparent conductive layer to form a 20 nm thick hole transport layer (NiOx + additive). In this case, cesium element was used as an additive, and the cesium element was included at 2 mol% based on the total mol% of the hole transport layer.
(3) Next, 2PACz ([2-(9H-Carbazol-9-yl)ethyl]phosphonic acid)) was coated on top of the hole transport layer by spin coating to form an interlayer with an average thickness of 3 nm.
(4) Next, 100 µL of a 1.3 M perovskite precursor solution having a perovskite crystal structure (Cs_{0.2}FA_{0.8}Pb(I_{0.8}Br_{0.2})₃) was dropped onto an upper part of the interlayer, spin-coated at 5,000 rpm for 30 seconds in a 99% pure nitrogen environment, and then heat-treated at 100°C for 20 minutes to form a 500 nm thick perovskite light-absorbing layer.
(5) Next, an electron transport layer (SnO₂) with an average thickness of 10 nm was formed on top of the perovskite light-absorbing layer through an atomic layer deposition (ALD) process.
(6) Next, a transparent electrode (ITO) with a thickness of 55 nm was formed on top of the electron transport layer through a sputtering process.
(7) Finally, silver (Ag) was deposited on top of the transparent electrode at a pressure of 1 × 10⁻⁷ torr with a thickness of 100 nm to form a metal electrode, thereby manufacturing a tandem silicon/perovskite heterojunction solar cell in which a silicon solar cell, a transparent conductive layer, a hole transport layer, an interlayer, a perovskite light-absorbing layer, an electron transport layer, a transparent electrode and a metal electrode were sequentially laminated.

### Example 2: Manufacture of tandem silicon/perovskite heterojunction solar cell

In the same manner as in Example 1, a tandem silicon/perovskite heterojunction solar cell was manufactured in which a silicon solar cell, a transparent conductive layer, a hole transport layer, an interlayer, a perovskite light-absorbing layer, an electron transport layer, a transparent electrode and a metal electrode were sequentially laminated. However, unlike in Example 1, when forming the hole transport layer, cesium element was included in an amount of 5 mol% based on the total mol% of the hole transport layer.

### Comparative Example 1: Manufacture of tandem silicon/perovskite heterojunction solar cell

(1) A silicon solar cell (thickness: 180 µm) doped with n or p-type impurities was prepared, the SiOₓ oxide film was removed by treating hydrofluoric acid, and the remaining hydrofluoric acid was removed by using ultrapure water. A 20 nm thick transparent conductive layer (ITO) was formed on top of the silicon solar cell from which the oxide film was removed through a sputtering process.
(2) Next, a NiOₓ nano colloidal solution was spin-coated on top of the transparent conductive layer to form a 20 nm thick hole transport layer (NiOₓ).
(3) Next, 2PACz ([2-(9H-Carbazol-9-yl)ethyl]phosphonic acid)) was coated on top of the hole transport layer by spin coating to form an interlayer with an average thickness of 3 nm.
(4) Next, 100 µL of a 1.3 M perovskite precursor solution having a perovskite crystal structure (Cs_{0.2}FA_{0.8}Pb(I_{0.8}Br_{0.2})₃) was dropped onto an upper part of the interlayer, spin-coated at 5,000 rpm for 30 seconds in a 99% pure nitrogen environment, and then heat-treated at 100°C for 20 minutes to form a 500 nm thick perovskite light-absorbing layer.
(5) Next, an electron transport layer (SnO₂) with an average thickness of 10 nm was formed on top of the perovskite light-absorbing layer through an atomic layer deposition (ALD) process.
(6) Next, a 75 nm thick transparent electrode (ITO) was formed on top of the electron transport layer through a sputtering process.
(7) Finally, silver (Ag) was deposited on top of the transparent electrode at a pressure of 1 × 10⁻⁷ torr with a thickness of 100 nm to form a metal electrode, thereby manufacturing a tandem silicon/perovskite heterojunction solar cell in which a silicon solar cell, a transparent conductive layer, a hole transport layer, an interlayer, a perovskite light-absorbing layer, an electron transport layer, a transparent electrode and a metal electrode were sequentially laminated.

### Comparative Example 2: Manufacture of tandem silicon/perovskite heterojunction solar cell

(1) A silicon solar cell (thickness: 180 µm) doped with n or p-type impurities was prepared, the SiOₓ oxide film was removed by treating hydrofluoric acid, and the remaining hydrofluoric acid was removed by using ultrapure water. A 20 nm thick transparent conductive layer (ITO) was formed on top of the silicon solar cell from which the oxide film was removed through a sputtering process.
(2) Next, a 20 nm thick hole transport layer (NiOₓ) was formed on top of the transparent conductive layer through a sputtering vacuum deposition process.
(3) Next, 2PACz ([2-(9H-Carbazol-9-yl)ethyl]phosphonic acid)) was coated on top of the hole transport layer by spin coating to form an interlayer with an average thickness of 3 nm.
(4) Next, 100 µL of a 1.3 M perovskite precursor solution having a perovskite crystal structure (Cs_{0.2}FA_{0.8}Pb(I_{0.8}Br_{0.2})₃) was dropped onto an upper part of the interlayer, spin-coated at 5,000 rpm for 30 seconds in a 99% pure nitrogen environment, and then heat-treated at 100°C for 20 minutes to form a 500 nm thick perovskite light-absorbing layer.
(5) Next, an electron transport layer (SnO₂) with an average thickness of 10 nm was formed on top of the perovskite light-absorbing layer through an atomic layer deposition (ALD) process.
(6) Next, a 75 nm thick transparent electrode (ITO) was formed on top of the electron transport layer through a sputtering process.
(7) Finally, silver (Ag) was deposited on the transparent electrode at a pressure of 1 × 10⁻⁷ torr with a thickness of 100 nm to form a metal electrode, thereby manufacturing a tandem silicon/perovskite heterojunction solar cell in which a silicon solar cell, a transparent conductive layer, a hole transport layer, an interlayer, a perovskite light-absorbing layer, an electron transport layer, a transparent electrode and a metal electrode were sequentially laminated.

### Experimental Example 1: Measurement of solar cell performance

For each of the tandem silicon/perovskite heterojunction solar cells manufactured in Examples 1 and 2 and Comparative Examples 1 and 2, the efficiency was measured by using a solar simulation device and a JV Keithley device and using the initial JV curve, and the results are shown in Table 1 below.

**[Table 1]**

| Classification | Open-circuit voltage (Voc, V) | Short-circuit current density (Jsc, mA/cm²) | Fill factor (FF) | Maximum power conversion efficiency (Best PCE, %) | Average power conversion efficiency (Avg. PCE, %) |
|---|---|---|---|---|---|
| Example 1 | 1.841 | 18.52 | 72.52 | 24.73 | 24.40 |
| Example 2 | 1.820 | 18.24 | 70.56 | 23.42 | 20.95 |
| Comparative Example 1 | 1.795 | 17.71 | 74.66 | 23.74 | 22.52 |
| Comparative Example 2 | 1.860 | 17.98 | 74.96 | 25.07 | 23.79 |

As can be confirmed in Table 1, the tandem silicon/perovskite heterojunction solar cell manufactured in Example 1 showed an increase in power conversion efficiency, as the open circuit voltage was improved.

### Experimental Example 2: Analysis of surface chemical properties of hole transport layer

The surface chemical properties of the hole transport layer of each of the tandem silicon/perovskite heterojunction solar cells manufactured in Examples 1 and 2 and Comparative Examples 1 and 2 were analyzed by photoelectron spectroscopy (XPS). Through this, the elemental composition and the chemical and electronic states of the atoms in the materials were measured.

FIG. 1 is a graph showing the intensity according to a change in binding energy. As can be confirmed in FIG. 1, compared to the tandem silicon/perovskite heterojunction solar cells manufactured in Comparative Examples 1 and 2, it was confirmed that the Ni³⁺ peak increased and the O³⁺ peak increased on the surface of the hole transport layer of the tandem silicon/perovskite heterojunction solar cell manufactured in Example 1, and through this, the doping effect by cesium atoms could be confirmed.

Meanwhile, it was confirmed that the defects due to cesium atoms increased and the effect due to doping decreased on the surface of the hole transport layer of the tandem silicon/perovskite heterojunction solar cell manufactured in Example 2.

### Experimental Example 3: Analysis of surface chemical properties of tandem silicon/perovskite heterojunction solar cells

The surface chemical properties of the tandem silicon/perovskite heterojunction solar cells manufactured in Example 1 and Comparative Examples 1 and 2 during the manufacturing process were analyzed by using photoelectron spectroscopy (XPS). Through this, the elemental composition and the chemical and electronic states of the atoms in the materials were measured.

Specifically, the surface chemical properties of the tandem silicon/perovskite heterojunction solar cells manufactured in Example 1 and Comparative Examples 1 and 2 in a state where up to the hole transport layer was manufactured (= Condition 1) were analyzed, the surface chemical properties in a state where an interlayer was formed on the hole transport layer (= Condition 2) were analyzed, the surface chemical properties in a state where a perovskite light-absorbing layer was formed on the interlayer (= Condition 3) were analyzed, and the surface chemical properties in a state where the perovskite light-absorbing layer was removed by using a perovskite light-absorbing layer removing solvent after forming the perovskite light-absorbing layer (= Condition 4) were analyzed, and the results are shown in Table 2 and FIG. 2 below.

**[Table 2]**

| Classification | | Work function (WF) | Valence band maximum (VBM) | Ionization energy (IE) | Ni | O | Cs |
|---|---|---|---|---|---|---|---|
| Condition 1 | Comparative Example 2 | 4.85 | 0.29 | 5.14 | 43.6 | 42.8 | - |
| | Comparative Example 1 | 4.96 | 0.45 | 5.41 | 44.7 | 44.6 | - |
| | Example 1 | 4.81 | 0.56 | 5.37 | 44.1 | 44.8 | 0.3 |
| Condition 2 | Comparative Example 2 | 5.37 | 0.56 | 5.91 | 23.1 | 32.3 | - |
| | Comparative Example 1 | 5.38 | 0.58 | 5.96 | 25.2 | 34.1 | - |
| | Example 1 | 5.14 | 0.80 | 5.94 | 24.1 | 33.1 | 1.2 |
| Condition 3 | Comparative Example 2 | 4.85 | 0.51 | 5.36 | - | 2.5 | 1.5 |
| | Comparative Example 1 | 5.28 | 0.66 | 5.94 | - | 3.0 | 1.6 |
| | Example 1 | 5.30 | 0.54 | 5.84 | - | 2.4 | 1.5 |
| Condition 4 | Comparative Example 2 | 5.14 | 0.53 | 5.67 | 28.1 | 33.0 | 0.4 |
| | Comparative Example 1 | 4.91 | 0.75 | 5.66 | 28.8 | 35.0 | 0.2 |
| | Example 1 | 4.81 | 0.81 | 5.62 | 31.5 | 37.3 | 0.1 |

The numerical values of each of nickel (Ni), oxygen (O) and cesium (Cs) elements listed in Table 2 represent the intensity of each element present at the upper surface. In other words, Ni in Condition 2 represents the intensity of Ni element observed at the surfaces of the hole transport layer/interlayer. Therefore, the reason why Ni in the interlayer decreased compared to Ni in the hole transport layer was that the element intensity of Ni decreased significantly as the interlayer was formed on top of the hole transport layer.

Meanwhile, as can be confirmed in Table 2, when an interlayer is coated on top of the hole transport layer, the surface is dominantly affected by the interlayer, and the work function and the valance band maximum value are changed by the interlayer. However, in the case of Example 1 where Cs was added, it was confirmed that the work function and the valence band maximum value were different from those of the interlayer of Comparative Example 1. At the same time, Cs significantly increased on the surface of the interlayer, which is determined to be due to the interaction between Cs and the interlayer at the surface due to the influence of Cs. In conclusion, it is determined that a difference occurred in the work function and the valence band maximum value at the interface, unlike Comparative Example 1 and Comparative Example 2.

Furthermore, Cs decreased the most when the perovskite light-absorbing layer was removed, and this is because the Cs interlayer was removed along with the perovskite light-absorbing layer.

The above has been illustrated and described with respect to specific embodiments. However, it is not limited to the above-described embodiments, and those skilled in the art to which the invention pertains can make various modifications and implementations without departing from the gist of the technical idea of the invention described in the claims below.

## Claims

1. A perovskite solar cell, comprising:
a laminate in which a hole transport layer, a perovskite light-absorbing layer, an electron transport layer, a transparent electrode and a metal electrode are sequentially laminated,
wherein an interlayer is formed between the hole transport layer and the perovskite light-absorbing layer, and
wherein the hole transport layer comprises an additive.

2. The perovskite solar cell of claim 1, wherein the additive comprises one or more selected from alkali metals and alkaline earth metals.

3. The perovskite solar cell of claim 1, wherein the hole transport layer comprises 1 to 7 mol% of an additive based on the total mol%.

4. The perovskite solar cell of claim 1, wherein the interlayer comprises a self-assembled monolayer comprising carbazole and phosphonic acid.

5. The perovskite solar cell of claim 1, wherein the hole transport layer and interlayer have a thickness ratio of 1 : 0.05 to 0.25.

6. The perovskite solar cell according to any one of claims 1 to 5, wherein the perovskite solar cell is a p-i-n structured perovskite solar cell, an n-i-p inverted structured perovskite solar cell, a tandem perovskite solar cell or a tandem silicon/perovskite heterojunction solar cell.

7. A method for manufacturing a perovskite solar cell, the method comprising:
a first step of forming a hole transport layer through a solution process on top of a transparent conductive layer;
a second step of forming an interlayer on top of the hole transport layer; and
a third step of forming a perovskite light-absorbing layer on top of the interlayer,
wherein the hole transport layer comprises an additive.

8. The method of claim 7, wherein the additive comprises one or more selected from alkali metals and alkaline earth metals.

9. The method of claim 7, wherein the hole transport layer comprises 1 to 7 mol% of an additive based on the total mol%.

10. The method of claim 7, wherein the interlayer comprises a self-assembled monolayer comprising carbazole and phosphonic acid.

11. A tandem silicon/perovskite heterojunction solar cell that is a heterojunction solar cell in which a solar cell, a transparent conductive layer, a hole transport layer, an interlayer, a perovskite light-absorbing layer, an electron transport layer, a transparent electrode and a metal electrode are sequentially laminated,
wherein the hole transport layer comprises an additive.

12. The tandem silicon/perovskite heterojunction solar cell of claim 11, wherein the additive comprises one or more selected from alkali metals and alkaline earth metals, and
wherein the interlayer comprises a self-assembled monolayer comprising carbazole and phosphonic acid.

13. The tandem silicon/perovskite heterojunction solar cell of claim 11, wherein the hole transport layer comprises 1 to 7 mol% of an additive based on the total mol%.

14. The tandem silicon/perovskite heterojunction solar cell of claim 11, wherein the solar cell is a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fuel-sensitized solar cell or a Group 3-5 compound solar cell.
